# EUROPÄISCHE PATENTSCHRIFT

(11) **EP 3 311 211 B1**
(45) Veröffentlichungstag und Bekanntmachung des Hinweises auf die Patenterteilung: **07.11.2018**
(21) Anmeldenummer: 16728600.4
(22) Anmeldetag: 27.05.2016
(51) Int. Cl.: F21S 41/19, F21S 41/14, F21S 41/16, H01S 5/00, G02B 7/00, G02B 7/02, G02B 27/09, F21Y 101/00

(54) **LASEREINHEIT MIT KOLLIMATOR-EINSTELLVORRICHTUNG**
LASER UNIT HAVING A COLLIMATOR ADJUSTING DEVICE
UNITÉ LASER DOTÉE D'UN DISPOSITIF DE RÉGLAGE DE COLLIMATEUR

(30) Priorität: 19.06.2015 AT 505172015
(43) Veröffentlichungstag der Anmeldung: 25.04.2018
(73) Patentinhaber: ZKW Group GmbH, 3250 Wieselburg (AT)
(72) Erfinder: MAYER, Matthias, 3240 Mank (AT)
(74) Vertreter: Patentanwaltskanzlei Matschnig & Forsthuber OG
(86) Internationale Anmeldenummer: PCT/AT2016/050166
(87) Internationale Veröffentlichungsnummer: WO 2016/201464

(56) Entgegenhaltungen:
- EP-A1- 1 359 450
- WO-A1-2015/106303
- DE-A1-102006 020 961
- KR-A- 20020 054 654
- US-A1- 2006 139 918
- US-B1- 6 198 580

## Beschreibung

Die Erfindung betrifft eine Lasereinheit für einen Fahrzeugscheinwerfer mit einer Laserlichtquelle, vorzugsweise Laserdiode, einem Lagergehäuse, in dem die Laserlichtquelle gelagert ist, und einer einstellbaren Kollimatoroptik für von der Laserlichtquelle ausgesandtes Laserlicht, wobei die Kollimatoroptik zumindest ein optisches Bauelement umfasst, das in einem entlang einer Längsrichtung verlaufenden Abstand zur Laserlichtquelle angeordnet ist.

Im Rahmen dieser Offenbarung bedeutet optisches Bauelement eine optische Komponente mit lichtsammelnden oder -streuenden Eigenschaften, und spezifischer einen Formreflektor (z.B. Hohl- oder Wölbspiegel) oder eine optische Linse, wobei auch Kombinationen aus diesen Komponenten eingeschlossen sein können. Unter Längsrichtung wird die Richtung der gedachten Achse verstanden, entlang der die Lichtausbreitung des Laserlichts aus der Laserlichtquelle zur Kollimatoroptik erfolgt.

Der Einsatz von Laser-Lichtquellen in Kraftfahrzeugen, insbesondere für Scheinwerfer von Kraftfahrzeugen, gewinnt derzeit an Bedeutung, da Laserdioden flexiblere und effizientere Lösungen ermöglichen, wodurch auch die Leuchtdichte des Lichtbündels sowie die Lichtausbeute erheblich gesteigert werden kann.

Bei den bekannten Lösungen wird der Laserstrahl allerdings nicht direkt aus der Beleuchtungsvorrichtung bzw. dem Scheinwerfer emittiert, um eine Gefährdung der Augen von Menschen und anderen Lebewesen durch den extrem gebündelten Lichtstrahl hoher Leistung zu vermeiden. Der Laser-Strahl wird vielmehr auf ein zwischengeschaltetes Konversionselement gerichtet, das ein Material zur Luminenszenzkonversion, kurz "Phosphor" genannt, enthält und das Laserlicht, beispielsweise einer Wellenlänge im blauen Bereich, in sichtbares Licht, vorzugsweise weißes Licht, umwandelt; dieses sichtbare Licht wird dann nach außen gelenkt. Im Rahmen der vorliegenden Erfindung wird unter "Phosphor" ganz allgemein ein Stoff oder eine Stoffmischung verstanden, welche Licht einer Wellenlänge in Licht einer anderen Wellenlänge oder eines Wellenlängengemisches, insbesondere in "weißes" Licht, umwandelt, was auch unter dem Begriff "Wellenlängenkonversion" subsumierbar ist. Zumeist ist dem Konversionselement ein programmiert verschwenkbarer Spiegel vorgeschaltet (hinsichtlich des Strahlengangs des Laserlichts), durch den der Laser-strahl auf verschiedene Orte auf dem flächigen Konversionselement gelenkt werden kann. Um zu erreichen, dass auf dem Konversionselement wohldefinierte Lichtpunkte oder (bei bewegtem Spiegel) Lichtmuster erzeugt werden, wird das von der Laserlichtquelle herrührende Licht mittels einer optischen Anordnung kollimiert, die hier als Kollimatoroptik bezeichnet wird. Die Kollimatoroptik ist in der Regel unmittelbar nach der Laserlichtquelle (hinsichtlich des Strahlengangs) angeordnet und kann mehrere optische Bauelemente und/oder das Licht begrenzende Komponenten umfassen, ist jedoch häufig durch eine einzelne optische Linse gebildet.

Aufgrund fertigungsbedingter Abweichungen der relativen Lage und Ausrichtung der Komponenten der Kollimatoroptik und Laserlichtquelle, aber auch um gegebenenfalls ein späteres Nachjustieren zu ermöglichen, ist es erforderlich, die optischen Bauelemente der Kollimatoroptik relativ zur Laserlichtquelle so einzustellen, dass ein Lichtpunkt mit gewünschter Schärfe auf dem Konversionselement erzeugt werden kann.

Es ist daher ein Ziel der Erfindung, eine genaue und zugleich unkomplizierte Justierung der Kollimatoroptik zu ermöglichen. Hierbei hat sich gezeigt, dass es vorteilhaft ist, nicht nur ein Einstellen der Ausrichtung, sondern auch des Abstands der optischen Komponente(n) der Kollimatoroptik zur Laserlichtquelle zu ermöglichen. Insbesondere bei Lasermodulen mit mehreren Laserlichtquellen ist ein individuelles Einstellen der einzelnen Laserstrahlen erforderlich.

Dieses Ziel wird erfindungsgemäß ausgehend von einer Lasereinheit der eingangs genannten Art durch eine der Kollimatoroptik zugeordneten Einstellvorrichtung mit einem Träger, der entlang der Längsrichtung relativ zu der Laserlichtquelle verstellbar ist, erreicht, wobei das zumindest eine optische Bauelement innerhalb des Trägers um zumindest eine zur Längsrichtung quer verlaufenden Raumachse schwenkbar gelagert ist.

Durch diese Lösung ergibt sich eine einfache und zuverlässige Justiermöglichkeit der Kollimatoroptik sowohl entlang der Längsrichtung als auch quer dazu, die auch nach dem Zusammenbau des optischen Systems (Laserlichtquelle, Kollimatoroptik, weiter Spiegel usw.) möglich ist. Auf diese Weise wird ermöglicht, die lichttechnisch äußerst wichtige, aber gegenüber Abweichungen sehr empfindliche Ausrichtung der Kollimatoroptik in Bezug auf die Laserlichtquelle einzustellen und Fehleinstellungen zu korrigieren. Bisher oftmals aufwendige Montagezyklen können daher vermieden werden. Ein weiterer Vorteil ist der große Einstellbereich, den diese technische Lösung erbringt.

In einer günstigen Weiterbildung der Erfindung kann in dem Lagergehäuse eine entlang der Längsrichtung verstellbare Längsstelleinrichtung vorgesehen sein, wobei der Träger gegen das zumindest eine Längsstellmittel abgestützt ist. Hierbei kann in einer der möglichen vorteilhaften Ausgestaltungen die Längsstelleinrichtung als eine Anzahl von parallel zur Längsrichtung verlaufenden Einstellschrauben realisiert sein. Um ein späteres Dejustieren hintan zu halten, kann die Längsstelleinrichtung zusätzlich in ihrer Längsposition feststellbar sein. Außerdem kann es zweckmäßig sein, wenn in dem Lagergehäuse zumindest ein elastisch verformbares Federelement vorgesehen ist, mit dem der Träger gegen das zumindest eine Längsstellmittel angedrückt wird.

In vielen Ausführungsformen ist eine Vereinfachung der Konstruktion der Lasereinheit dadurch erzielbar, dass der Träger in dem Lagergehäuse entlang der Längsrichtung verstellbar, wogegen die Laserlichtquelle in dem Lagergehäuse fest positioniert ist.

Um eine höhere Flexibilität der optischen Einstellungsmöglichkeiten zu erreichen, kann es günstig sein, wenn das zumindest eine optische Bauelement um zwei Raumachsen schwenkbar gelagert ist, wobei die zueinander senkrechten Raumachsen senkrecht zur Längsrichtung liegen.

In einer vorteilhaften Weiterbildung der Erfindung hinsichtlich der Verwirklichung der Schwenkung der Kollimatoroptik kann vorgesehen sein, dass in dem Träger eine Halterung, in der das optischen Element gehalten ist, sowie zumindest ein an der Halterung angreifender Hebel - vorzugsweise zwei - vorgesehen sind, wobei an einem äußeren Ende des bzw. jedes Hebels ein in dem Träger gelagertes Stellmittel vorgesehen ist, mit dem der Hebel hinsichtlich seiner Schwenkposition einstellbar ist.

Es kann außerdem vorgesehen sein, dass jeweils ein elastisch verformbares Federelement zwischen einem Hebel und einer Gegenfläche des Trägers angeordnet ist und der zumindest eine Hebel jeweils von einem Stellmittel, vorzugsweise einer exzentrisch verlaufenden Stellschraube, über das Federelement gegen die Gegenfläche angedrückt wird.

Des Weiteren kann vorgesehen sein, dass der Hebel mit dem zugehörenden Stellmittel über eine Gelenkverbindung verbunden ist, wobei die Gelenkverbindung zwischen einer Endfläche des Stellmittels und einer diese berührende Kontaktfläche des Hebels gebildet ist, wobei vorzugsweise die Endfläche und/oder die Kontaktfläche als kugelartig gewölbte Berührungsfläche ausgebildet sind.

Um spätere Abweichungen einer einmal erreichten Justierung zu unterbinden, kann das bzw. die Stellmittel zusätzlich drehfest festlegbar sein.

Außerdem kann es die Herstellung vereinfachen, wenn die Halterung und der zumindest eine Hebel einstückig miteinander ausgebildet sind.

Die Erfindung eignet sich insbesondere für eine Lasermodul mit einer Mehrzahl von Lasereinheiten der vorangehend beschriebenen Art, sowie für einen Fahrzeugscheinwerfer, insbesondere für KFZ, mit einer Lasereinheit bzw. einem Lasermodul wie vorangehend beschrieben.

Die Erfindung samt weiterer Weiterbildungen und Vorzüge wird im Folgenden anhand eines Ausführungsbeispiels näher erläutert, das in den Zeichnungen dargestellt ist und eine Lasereinheit mit einer Laserdiode in einem Lasermodul für einen KFZ-Scheinwerfer betrifft. Die Zeichnungen zeigen in schematischer Form:
- Fig. 1: eine Ansicht einer Lasereinheit in einem Lasermodul gemäß dem Ausführungsbeispiel, mit Blick auf die Außenseite der Lasereinheit, über die die Stellbauteile zugänglich sind;
- Fig. 2: eine Schnittansicht der Lasereinheit gemäß dem Schnitt A-A der Fig. 1;
- Fig. 3: eine perspektivische Ansicht der Einstellvorrichtung der Lasereinheit;
- Fig. 4: eine perspektivische Ansicht des Trägers in der Einstellvorrichtung der Fig. 3 mit einem Linsenhalter;
- Fig. 5: eine Variante des Linsenhalters; und
- Fig. 6: einen Scheinwerfer mit dem Lasermodul der Fig. 1.

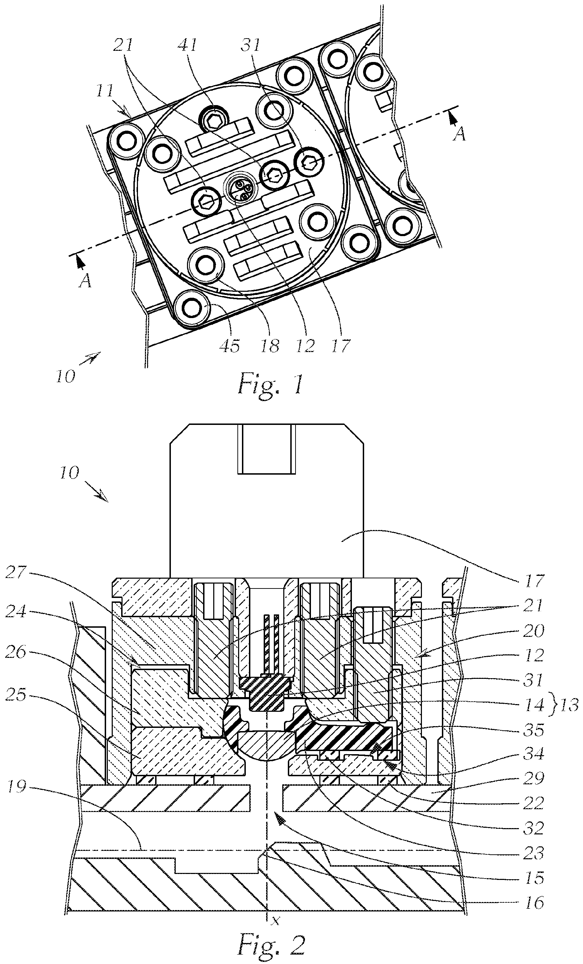

Bezugnehmend auf Fig. 1 und 2 enthält ein Lasermodul 10 ein oder mehrere Lasereinheiten 11 mit jeweils einer Laserlichtquelle 12, die in dem gezeigten Beispiel als Laserdiode ausgebildet ist; jedoch sind andere Laserquellen bekannter Art in entsprechender Weise verwendbar. Die Lasereinheiten 11 sind beispielsweise in dem Lasermodul 10 entlang eines Abstrahllichtweges 19 nebeneinander aufgereiht, in den das von der Lasereinheit 11 durch eine ihr zugehörende Abstrahlöffnung 15 ausgesandte Licht über einen Spiegel 16 eingekoppelt wird.

Der Laserlichtquelle 12 ist eine Kollimatoroptik 13 zugeordnet, die im dargestellten Ausführungsbeispiel durch eine einzelne Sammellinse 14 (Kollimatorlinse) verwirklicht ist und im Strahlgang unmittelbar nach der Lichtquelle 12 angeordnet ist. Der Strahlgang von der Laserlichtquelle 12 zur Kollimatoroptik 13 verläuft entlang der Längsrichtung x im Sinne der Erfindung (in Fig. 2 vertikal). Die Abstrahlöffnung 15 und der Spiegel 16 liegen im Ausführungsbeispiel ebenfalls in der (verlängerten) Längsrichtung x.

Fig. 1 zeigt die Außenseite der Lasereinheit 11. In der Mitte der Lasereinheit 11 ist die Laserdiode 12 eingesetzt, wobei in der Figur die elektrischen Anschlüsse der Laserdiode erkennbar sind. Auf der Außenseite können ein oder mehrere Kühlkörper 17 aufgebracht sein; in der Darstellung der Fig. 1 sind der Deutlichkeit halber die Kühlrippen des Kühlkörpers 17 gekürzt dargestellt. Der Kühlkörper 17 weist neben einer Öffnung für die bereits erwähnten elektrischen Anschlüsse der Laserdiode 12 weitere Öffnungen auf, durch die Stellbauteile der erfindungsgemäßen Einstellvorrichtung, nämlich im gezeigten Ausführungsbeispiel die Köpfe von Einstellschrauben 21, 31, 41, von außen zugänglich sind. Außerdem sind erste Befestigungsschrauben 45, mit denen die Lasereinheit 11 im Gehäuse des Lasermoduls 10 montiert ist, sowie zweite Befestigungsschrauben 18 zur Befestigung des Kühlkörpers 17 erkennbar.

In Fig. 2 ist die erfindungsgemäße Einstellvorrichtung 20 für die Kollimatoroptik 13 in einer Längsschnittansicht der Lasereinheit 11 erkennbar. Die Lasereinheit 11 umfasst insbesondere einen Linsenhalter 23, der die Linse 14 hält, diesen zugeordnete Stellbauteile (Stellschrauben) 21, 31, 41 und Federelemente 22, 32, 42, einen Träger 24 (Halteraufnahme) für den Linsenhalter, und ein Lagergehäuse 27 mit der darin gehaltenen Laserlichtquelle 12. Der Linsenhalter 23, in dem die Kollimatorlinse 14 eingesetzt ist, ist in dem Träger 24 schwenkbar gelagert, der wiederum in dem Lagergehäuse 27 entlang der Längsrichtung x verschieblich gelagert ist. Der Träger 24 ist aus zwei Bauteilen von scheibenartiger Grundform zusammengesetzt, nämlich einem Stirnteil 25 und einem Rückenteil 26.

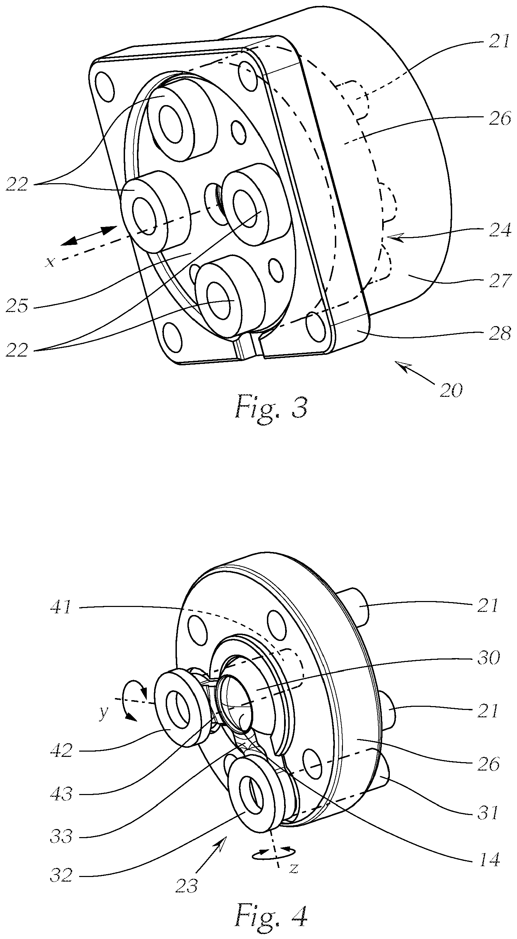

Bezugnehmend auf Fig. 2 und 3 hat das Lagergehäuse 27 die Grundform eines Bechers, dessen Boden (Fig. 1) nach außen gerichtet ist und dem ein Flansch 28 mit einer z.B. quaderartigen Ausbildung (Fig. 3) angefügt, bevorzugt einstückig angeformt, ist. Das Lagergehäuse 27 ist an der der Öffnung des Bechers entsprechenden Seite einer - mit Bezugszeichen 29 bezeichnete - Auflagefläche des Gehäuses des Lasermoduls 10 aufgelegt, wodurch das Lagergehäuse 27 mit dem darin untergebrachten Träger 24 von der Auflagefläche (wie durch einen Deckel) geschlossen ist. Mithilfe des Flansches 28 kann das Lagergehäuse 27 an der Auflagefläche 29 befestigt, z.B. an den vier Enden mithilfe der Befestigungsschrauben 45, angeschraubt, werden. Durch die Auflagefläche 29 verläuft die oben erwähnte Abstrahlöffnung 15 der Lasereinheit 11.

Die Position des Trägers 24 entlang der Richtung x wird in dem Lagergehäuse 27 durch Längsstellmittel eingestellt, die in der gezeigten Ausführungsform als zwei Einstellschrauben 21 ausgeführt sind. Die Einstellschrauben 21 sind parallel zur Längsrichtung x und einander gegenüber in Bezug auf die Position der Laserdiode 12 angeordnet. Die Köpfe der Einstellschrauben 21 sind an der Außenseite (Fig. 1) der Lasereinheit zugänglich, sodass hier z.B. Sechskantschlüssel oder anderes geeignetes Werkzeug angesetzt werden können, um die Einstellschrauben 21 auf eine gewünschte Position der Längsrichtung x einzustellen. Die Einstellschrauben 21 wirken auf den Träger 24, genauer gesagt auf die Außenseite des Rückenteils 26 des Trägers 24. Der Träger 24 wird durch Gummifedern 22, die zwischen ihm - nämlich auf der Stirnfläche des Stirnteils 25 (vgl. Fig. 3) - und der Auflagefläche 29 angeordnet sind, gegen die Einstellschrauben 21 gedrückt. Dadurch wird der Träger 24 gegen das Gehäuse vorgespannt, er stützt sich stets auf den Endflächen der Einstellschrauben 21 ab, und ein Spiel des Trägers 24 wird vermieden. Die Längseinstellung gemäß dem gezeigten Ausführungsbeispiel ermöglicht eine gesamte Verschiebung in der Größenordnung von ca. ±1 mm.

In Fig. 4 ist der Linsenhalter 23 mit den zugehörenden Stellmitteln gezeigt; der Träger 24 ist eröffnet, nämlich mit abgenommenem Stirnteil 25, sodass nur der Rückenteil 26 dargestellt ist. Bezugnehmend auf Fig. 2 und 4 weist der Linsenhalter 23 einen mittigen Körper 30 auf, dessen äußere Gestalt die eines Ringes mit kugelzonenförmigen Außenflächen ist. Die Kollimatorlinse 14 ist dem Körper 30 eingesetzt, nämlich in einer Vertiefung des Körpers gegenüber der Seite, durch die die Laserlichtquelle 12 das Licht zum Linsenhalter hin aussendet; die Linse kann in der Vertiefung z.B. durch Klebung fixiert sein. Der Träger 24 weist einen hohlkugelartigen Hohlraum auf, in den der Körper 30 des Linsenhalters 23 aufgenommen ist, sodass letzterer in dem Träger 24 nach Art eines Kugelgelenks gelagert ist.

In dem Rückenteil 26 sind zwei Stellmittel 31, 41 vorgesehen, durch die der Linsenhalter 23 - und somit die darin gehaltene Kollimatorlinse 14 - um eine jeweils zugordnete Raumachse, die quer zur Längsrichtung verläuft, verschwenkt werden kann. Jedes der beiden Stellmittel ist in der gezeigten Ausführungsform als Stellschraube 31, 41 ausgeführt, die parallel zur Längsrichtung exzentrisch zur Position der Kollimatorlinse 14 angeordnet sind. Die Köpfe der Stellschrauben 31, 41 sind durch das Lagergehäuse 27 geführt und somit an der Außenseite (Fig. 1) der Lasereinheit zugänglich, sodass mittels geeigneten Werkzeugs die Stellschrauben 31, 41 auf eine gewünschte Position eingestellt werden können.

Die Stellschraube 31 dient dem Einstellen der Schwenkposition der Kollimatorlinse 14 um eine erste transversale Achse, der y-Achse; die Stellschraube 41 dient dem Einstellen der Schwenkposition der Kollimatorlinse 14 um eine zweite transversale Achse, der z-Achse.

Die Stellschraube 31 wirkt auf einen Hebel 33, der sich quer von der Achse der Lichtausbreitung von dem Körper 30 des Linsenhalters 23 erstreckt, und drückt diesen über eine Gummifeder 32 gegen eine innere Gegenfläche 34 (Fig. 2) im Stirnteil 25 des Trägers 24. Diese Gummifeder ist vorzugsweise als flacher Gummiring ausgebildet, was zusätzlich ermöglicht, innerhalb des Gummirings (d.h. in dessen inneren Öffnung) eine erhöhte Anschlagfläche 35 auszubilden, die bevorzugter Weise schräg ausgebildet werden kann, um als paralleler und somit flächiger Anschlag zur Endstellung des Hebels zu wirken, siehe Fig.2. Hierbei ist es günstig, wenn die Endfläche der Stellschraube 31 und/oder die zugeordnete Kontaktfläche des Hebels 33 gewölbt geformt ist, beispielsweise kugelartig gewölbt; auf diese Weise ergibt sich an der Stelle der Berührung dieser beiden Flächen eine definierte Gelenkverbindung. Durch die Wirkung der Gummifeder 32 wird der Hebel gegen den Träger vorgespannt; ein Spiel zwischen Stellschraube 31 und Hebel 33 vermieden.

Die Stellschraube 41 wirkt auf einen Hebel 43, der sich von dem Körper 30 des Linsenhalters 23 in einer anderen Richtung als der Hebel 33 erstreckt; die Hebel 33 und 43 sind bevorzugt zueinander um 90° versetzt um die Längsachse angeordnet. Der Hebel 43 wird über eine Gummifeder 42 gegen die innere Gegenfläche 34 gedrückt. Im Übrigen gilt das zum Hebel 33 Gesagte für den Hebel 43 in analoger Weise.

Die Drehachse ist jeweils durch die Verlängerung des Mittelpunkts des Kugelgelenks zum Auflagepunkt des Stellmittels 31, 41 am Ende des jeweils zugeordneten Hebels 33, 43 des Linsenhalters 23 definiert. Diese Drehachsen entsprechen den Achsen y und z der Fig. 4. Mit den Stellschrauben 31, 41 ist ein Einstellen der Schwenkposition um insgesamt ±1,5° möglich. Die Genauigkeit beträgt beispielsweise 0,5° pro Umdrehung; besonders bevorzugt 0,1° pro Umdrehung.

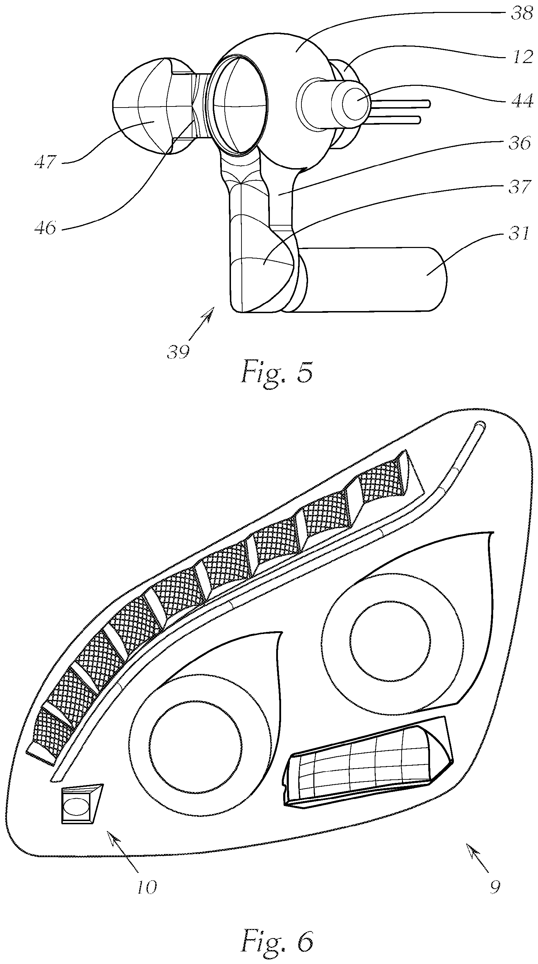

Fig. 5 zeigt eine Variante des Linsenhalters mit abgewandelten Hebeln 36, 46 und abgewandeltem Körper 38 des Linsenhalters 39. Da die Hebel 36, 46 bei der Verdrehung über den jeweils anderen Hebel 46, 36 mit-verschwenkt werden, sind diese wie in Fig. 5 gezeigt vorteilhafter Weise mit Rundungen 37, 47 versehen, womit für jede Stellung eine gleiche Druckstelle der Gegenfläche 34 beaufschlagt wird. Zusätzlich kann am Körper 38 ein zylinderförmiger Ansatz 44 ausgebildet sein, welcher im (nicht gezeigten) Träger entsprechend gelagert ist. Beide in Fig. 5 dargestellten Abwandlungen ermöglichen eine flüssigere Schwenkung um die beiden Achsen der Hebel 36, 46.

Der Justiervorgang der Kollimatoroptik 13 mithilfe der erfindungsgemäßen Einstellvorrichtung 20 erfolgt beispielsweise wie folgt. Die Laserlichtquelle 12 wird aktiviert und der auf der Zielfläche (d.i. in der Regel der oben erwähnte programmiert verschwenkbare Spiegel bzw. das als Phosphor dienende Konversionselement) erzeugte Lichtfleck (Laserspot) wird beobachtet bzw. gemessen. Im Allgemeinen befindet sich der Laserspot außerhalb des für den Betrieb geforderten Zielorts im Zentrum der Zielfläche und ist zudem defokussiert. Zuerst wird durch Einstellen der Stellschrauben 31 und 41 die Position des Laserspots verändert, bis der Laserspot auf dem Zielort liegt, der typischer Weise eine Ausdehnung von wenigen Millimetern (z.B. 2-3 mm) hat. Sodann wird die Kollimatoroptik in der Längsrichtung x mithilfe der Einstellschrauben 21 verschoben, bis der Laserspot auf der zugehörenden Zielfläche wie gefordert fokussiert ist. Zum Einstellen kann beispielsweise eine Lehre verwendet werden, welche einen Sensor beinhaltet, der so angeordnet wird, dass er dem Zielort entspricht und so einen Rückgabewert für die zuvor beschriebene Einstellung bereitstellt. Im Zuge der Montage wird anschließend das für den Zielort vorgesehene optische Element positioniert.

Falls gewünscht, können die Einstellmittel 21, 31, 41 nach dem Einjustieren der Kollimatoroptik bzw. -linse 13, 14 in der eingestellten Position dauerhaft festgestellt werden. Das kann beispielsweise durch eine Klemmung des Schraubenkopfes oder durch Auftragen eines aushärtenden Klebstoffs um den Schraubenkopf erfolgen.

Das Lasermodul 10 mit der so eingestellten Kollimatoroptik 13 kann sodann in einen Scheinwerfer 9 - in Fig. 6 in teilweise aufgeschnittener Ansicht gezeigt - an der hierfür vorgesehenen Position eingesetzt werden.

Es sei hervorgehoben, dass das Ausführungsbeispiel zum Zweck der Illustration dient und nicht einschränkend auszulegen ist. So können z.B. anstelle der Stellschrauben andere geeignete Vorrichtungen zum mechanischen oder elektromechanischen Einstellen von Hand und/oder durch Stellmotoren vorgesehen sein. In einer Variante, in der eine Schwenkung der Linse um nur eine Achse ausreicht, kann anstelle einer kugelgelenkartigen Ausgestaltung auch ein Drehgelenk verwendet werden. Auch kann die Kollimatoroptik, die im oben gezeigten Ausführungsbeispiel durch eine (einzelne) Linse verwirklicht ist, in anderen Ausgestaltungen der Erfindung mithilfe mehrerer Linsen, eines oder mehrerer Spiegel oder eine Kombination derartiger optischen Bauelemente ausgeführt sein. Des Weiteren können die Federelemente als Gummifedern oder andere elastische Komponenten verwirklicht werden, wie z.B. Spiral- oder Blattfedern. Allgemein sind im Rahmen der Erfindung zahlreiche Abwandlungen und Weiterbildungen möglich, die der Fachmann ohne Weiteres auffinden kann.

## Patentansprüche

1. Lasereinheit (11) für einen Fahrzeugscheinwerfer mit einer Laserlichtquelle (12), vorzugsweise Laserdiode, einem Lagergehäuse (27), in dem die Laserlichtquelle gelagert ist, und einer einstellbaren Kollimatoroptik (13) für von der Laserlichtquelle ausgesandtes Laserlicht, wobei die Kollimatoroptik zumindest ein optisches Bauelement (14) umfasst, das in einem entlang einer Längsrichtung (x) verlaufenden Abstand zur Laserlichtquelle angeordnet ist,
wobei die Lasereinheit (11) eine der Kollimatoroptik (13) zugeordneten Einstellvorrichtung (20) mit einem Träger (24) aufweist, wobei der Träger (24) entlang der Längsrichtung (x) relativ zu der Laserlichtquelle (12) verstellbar ist, **dadurch gekennzeichnet, dass** das zumindest eine optische Bauelement (14) innerhalb des Trägers (24) um zumindest eine zur Längsrichtung quer verlaufenden Raumachse (y, z) schwenkbar gelagert ist.

2. Lasereinheit nach Anspruch 1, **dadurch gekennzeichnet, dass** in dem Lagergehäuse (27) eine entlang der Längsrichtung verstellbare Längsstelleinrichtung (21) vorgesehen ist, wobei der Träger (24) gegen die Längsstelleinrichtung (21) abgestützt ist.

3. Lasereinheit nach Anspruch 2, **dadurch gekennzeichnet, dass** die Längsstelleinrichtung (21) als eine Anzahl von parallel zur Längsrichtung (x) verlaufenden Einstellschrauben ausgebildet ist.

4. Lasereinheit nach Anspruch 2 oder 3, **dadurch gekennzeichnet, dass** die Längsstelleinrichtung (21) zusätzlich in ihrer Längsposition feststellbar ist.

5. Lasereinheit nach einem der Ansprüche 2 bis 4, **dadurch gekennzeichnet, dass** in dem Lagergehäuse (27) zumindest ein elastisch verformbares Federelement (22) vorgesehen ist, mit dem der Träger (24) gegen die Längsstelleinrichtung (21) angedrückt wird.

6. Lasereinheit nach einem der vorhergehenden Ansprüche, **dadurch gekennzeichnet, dass** der Träger (24) in dem Lagergehäuse (27) entlang der Längsrichtung verstellbar, jedoch die Laserlichtquelle (12) in dem Lagergehäuse (27) fest positioniert ist.

7. Lasereinheit nach einem der vorhergehenden Ansprüche, **dadurch gekennzeichnet, dass** das zumindest eine optische Bauelement (14) um zwei Raumachsen (y, z) schwenkbar gelagert ist, wobei die zueinander senkrechten Raumachsen senkrecht zur Längsrichtung (x) liegen.

8. Lasereinheit nach einem der vorhergehenden Ansprüche, **dadurch gekennzeichnet, dass** in dem Träger (24) eine Halterung (23), in der das optischen Element (14) gehalten ist, sowie zumindest ein an der Halterung angreifender Hebel (33, 43), vorzugsweise zwei, vorgesehen sind, wobei an einem äußeren Ende des bzw. jedes Hebels (33, 43) ein in dem Träger (24) gelagertes Stellmittel (41, 31) vorgesehen ist, mit dem der Hebel hinsichtlich seiner Schwenkposition einstellbar ist.

9. Lasereinheit nach Anspruch 8, **dadurch gekennzeichnet, dass** jeweils ein elastisch verformbares Federelement (32, 42) zwischen einem Hebel (33, 43) und einer Gegenfläche (34) des Trägers (24) angeordnet ist und der zumindest eine Hebel (33, 43) jeweils von einem Stellmittel (31, 41), vorzugsweise einer exzentrisch verlaufenden Stellschraube, über das Federelement (32, 42) gegen die Gegenfläche (34) angedrückt wird.

10. Lasereinheit nach Anspruch 8 oder 9, **dadurch gekennzeichnet, dass** der Hebel (33, 43) mit dem zugehörenden Stellmittel (31, 41) über eine Gelenkverbindung verbunden ist, wobei die Gelenkverbindung zwischen einer Endfläche des Stellmittels und einer diese berührende Kontaktfläche des Hebels gebildet ist, wobei die Endfläche und/oder die Kontaktfläche vorzugsweise als kugelartig gewölbte Berührungsfläche ausgebildet sind.

11. Lasereinheit nach einem der Ansprüche 8 bis 10, **dadurch gekennzeichnet, dass** das/die Stellmittel (31, 41) zusätzlich drehfest festlegbar ist/sind.

12. Lasereinheit nach einem der Ansprüche 8 bis 11, **dadurch gekennzeichnet, dass** die Halterung (23) und der zumindest eine Hebel (33, 43) einstückig miteinander ausgebildet sind.

13. Lasermodul (10) umfassend eine Mehrzahl von Lasereinheiten (11) nach einem der vorhergehenden Ansprüche.

14. Fahrzeugscheinwerfer (9) mit einer Lasereinheit (11) nach einem der Ansprüche 1 bis 12 und/oder einem Lasermodul (10) nach Anspruch 13.

## Claims

1. A laser unit (11) for a vehicle headlight, comprising a laser light source (12), preferably a laser diode,
a bearing housing (27) in which the laser light source is mounted, and an adjustable collimator optical unit (13) for laser light emitted by the laser light source,
the collimator optical unit comprising at least one optical component (14) which is arranged at a distance in the longitudinal direction (x) from the laser light source, the laser unit (11) comprising an adjusting device (20) associated with the collimator optical unit (13) and having a carrier (24), the carrier (24) being displaceable in the longitudinal direction (x) relative to the laser light source (12), **characterised in that** the at least one optical component (14) is mounted in the carrier (24) pivotably about at least one spatial axis (y, z) running transversely to the longitudinal direction.

2. The laser unit according to Claim 1, **characterised in that** in the bearing housing (27) there is provided a longitudinal actuating device (21) which is adjustable in the longitudinal direction, wherein the carrier (24) is supported against the longitudinal actuating device (21).

3. The laser unit according to Claim 2, **characterised in that** the longitudinal actuating device (21) is in the form of a number of adjusting screws running parallel to the longitudinal direction (x).

4. The laser unit according to Claim 2 or 3, **characterised in that** the longitudinal actuating device (21) can also be fixed in its longitudinal position.

5. The laser unit according to any one of Claims 2 to 4, **characterised in that** in the bearing housing (27) there is provided at least one elastically deformable spring element (22) with which the carrier (24) is pressed against the longitudinal actuating device (21).

6. The laser unit according to any one of the preceding claims, **characterised in that** the carrier (24) is displaceable in the longitudinal direction in the bearing housing (27) but the laser light source (12) is fixed in position in the bearing housing (27).

7. The laser unit according to any one of the preceding claims, **characterised in that** the at least one optical component (14) is mounted pivotably about two spatial axes (y, z), wherein the mutually perpendicular spatial axes are perpendicular to the longitudinal direction (x).

8. The laser unit according to any one of the preceding claims, **characterised in that** in the carrier (24), there are provided a holder (23) in which the optical element (14) is held and at least one lever, preferably two levers, (33, 43) acting on the holder, wherein on an outer end of the or each lever (33, 43) there is provided an actuating means (41, 31) which is mounted in the carrier (24) and with which the pivot position of the lever can be adjusted.

9. The laser unit according to Claim 8, **characterised in that** in each case, a respective elastically deformable spring element (32, 42) is disposed between a lever (33, 43) and a mating surface (34) of the carrier (24), and the at least one lever (33, 43) is pressed by a respective actuating means (31, 41), preferably eccentric actuating screw, via the spring element (32, 42) against the mating surface (34).

10. The laser unit according to Claim 8 or 9, **characterised in that** the lever (33, 43) with the associated actuating means (31, 41) is connected via an articulation, wherein the articulation is formed between an end face of the actuating means and a contact face of the lever which touches said end face, wherein the end face and/or the contact face are preferably in the form of spherically curved touching faces.

11. The laser unit according to any one of Claims 8 to 10, **characterised in that** the actuating means (31, 41) can also be rotationally fixed in position.

12. The laser unit according to any one of Claims 8 to 11, **characterised in that** the holder (23) and the at least one lever (33, 43) are formed integrally with each other.

13. A laser module (10) comprising a plurality of laser units (11) according to any one of the preceding claims.

14. A vehicle headlight (9) comprising a laser unit (11) according to any one of Claims 1 to 12 and/or comprising a laser module (10) according to Claim 13.

## Revendications

1. Unité laser (11) pour un phare de véhicule, comportant une source de lumière laser (12), de préférence une diode laser, un boîtier de support (27) dans lequel la source de lumière laser est montée, et une optique de collimation réglable (13) pour de la lumière laser émise par la source de lumière laser, l'optique de collimation comportant au moins un composant optique (14), qui est disposé à une distance s'étendant le long d'une direction longitudinale (x) par rapport à la source de lumière laser,
l'unité laser (11) présentant un dispositif de réglage (20) associé à l'optique de collimation (13) et comportant un support (24), le support (24) étant réglable le long de la direction longitudinale (x) par rapport à la source de lumière laser (12),
**caractérisée par le fait que** ledit au moins un composant optique (14) à l'intérieur du support (24) est monté pivotant autour d'au moins un axe spatial (y, z) s'étendant transversalement à la direction longitudinale.

2. Unité laser selon la revendication 1, **caractérisée par le fait que**, dans le boîtier de support (27), est prévu un dispositif de réglage en longueur (21) réglable le long de la direction longitudinale, le support (24) étant supporté contre le dispositif de réglage en longueur (21).

3. Unité laser selon la revendication 2, **caractérisée par le fait que** le dispositif de réglage en longueur (21) est réalisé en tant qu'une pluralité de vis de réglage s'étendant parallèlement à la direction longitudinale (x).

4. Unité laser selon l'une des revendications 2 ou 3, **caractérisée par le fait que** le dispositif de réglage en longueur (21) est apte à être fixé en outre dans sa position longitudinale.

5. Unité laser selon l'une des revendications 2 à 4, **caractérisée par le fait que**, dans le boîtier de support (27), est prévu au moins un élément ressort élastiquement déformable (22), avec lequel le support (24) est pressé contre le dispositif de réglage en longueur (21).

6. Unité laser selon l'une des revendications précédentes, **caractérisée par le fait que** le support (24) est réglable le long de la direction longitudinale dans le boîtier de support (27) mais la source de lumière laser (12) est fixée en position dans le boîtier de support (27).

7. Unité laser selon l'une des revendications précédentes, **caractérisée par le fait que** ledit au moins un composant optique (14) est monté pivotant autour de deux axes spatiaux (y, z), les axes spatiaux perpendiculaires entre eux s'étendant perpendiculairement à la direction longitudinale (x) .

8. Unité laser selon l'une des revendications précédentes, **caractérisée par le fait que**, dans le support (24), sont prévus un élément de maintien (23), dans lequel le composant optique (14) est maintenu, ainsi qu'au moins un levier (33, 43), de préférence deux, agissant sur l'élément de maintien, un moyen de réglage (41, 31) monté dans le support (34) étant prévu à une extrémité externe du ou de chaque levier (33, 43), moyen de réglage avec lequel le levier est régable en ce qui concerne sa position de pivotement.

9. Unité laser selon la revendication 8, **caractérisée par le fait qu'**un élément ressort élastiquement déformable (32, 42) est disposé entre chaque levier (33, 43) et une face opposée (34) du support (24) et chacun dudit au moins un levier (33, 43) est pressé contre la face opposée (34) par l'élément ressort (32, 42), par un moyen de réglage (31, 41), de préférence une vis de réglage s'étendant de façon excentrique.

10. Unité laser selon l'une des revendications 8 ou 9, **caractérisée par le fait que** le levier (33, 43) est relié au moyen de réglage associé (31, 41) par une liaison articulée, la liaison articulée étant formée entre une face d'extrémité du moyen de réglage et une face de contact du levier touchant celle-ci, la face d'extrémité et/ou la face de contact étant réalisées de préférence comme face de contact à courbure sphérique.

11. Unité laser selon l'une des revendications 8 à 10, **caractérisée par le fait que** le/les moyens de réglage (31, 41) est/sont en outre aptes à être fixés de manière solidaire en rotation.

12. Unité laser selon l'une des revendications 8 à 11, **caractérisée par le fait que** l'élément de maintien (23) et ledit au moins un levier (33, 43) sont réalisés d'un seul tenant entre eux.

13. Module laser (10) comportant une pluralité d'unités laser (11) selon l'une des revendications précédentes.

14. Phare de véhicule (9) comportant une unité laser (11) selon l'une des revendications 1 à 12 et/ou un module laser (10) selon la revendication 13.
